Europäisches Patentamt

(19) European Patent Office

Office européen des brevets

(11) Veröffentlichungsnummer: **0 047 935**

**A2**

(12) ## EUROPÄISCHE PATENTANMELDUNG

(21) Anmeldenummer. **81106965.7**

(22) Anmeldetag: **04.09.81**

(51) Int. Cl.³: **H 05 K 1/00**
**H 01 R 23/72**

(30) Priorität: **11.09.80 DE 3034259**

(43) Veröffentlichungstag der Anmeldung:
**24.03.82 Patentblatt 82/12**

(84) Benannte Vertragsstaaten:
**AT CH DE FR GB IT LI NL SE**

(71) Anmelder: SIEMENS AKTIENGESELLSCHAFT Berlin
und München
Postfach 22 02 61
D-8000 München 22(DE)

(72) Erfinder: Keller, Roman
Grossenbuch Nr. 126
D-8524 Neunkirchen a. Br.(DE)

(72) Erfinder: Assel, Eugen
Hauptstrasse 6
D-8729 Knetzgau(DE)

(54) **Leiterplatte.**

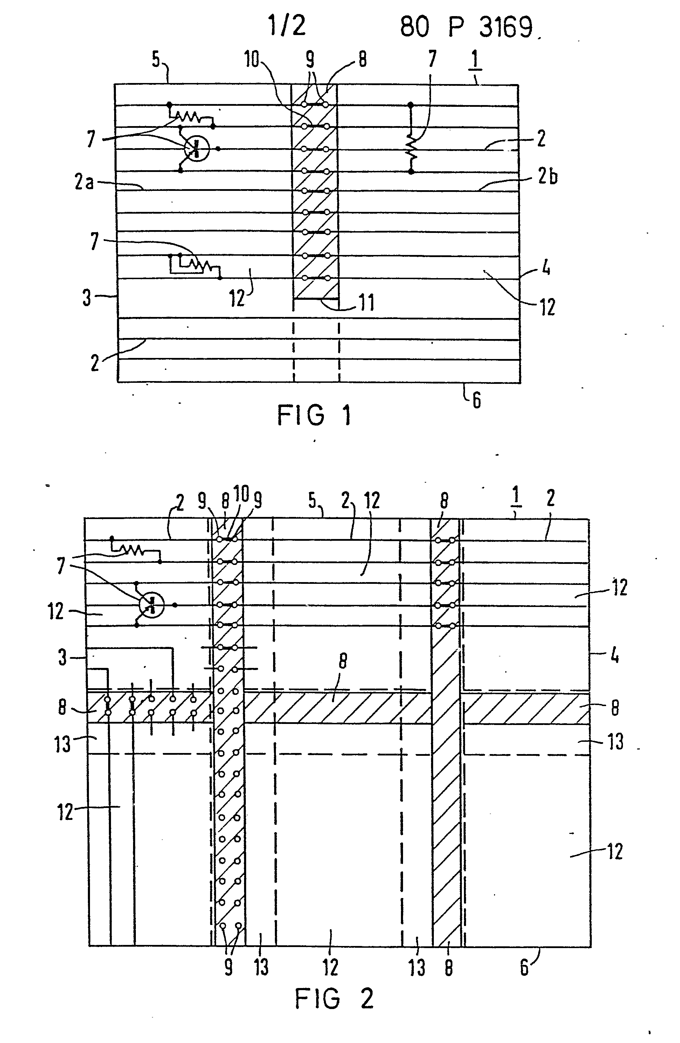

(57) Die Erfindung betrifft eine Leiterplatte mit Leiterbahnen zur Verdrahtung elektrischer Bauelemente. Eine Leiterplatte (1) ist durch mehrere Schnittstellen (8) ihrer Verdrahtung rasterartig in mehrere Bestückungsflächen (12) unterteilt. In jeder Schnittstelle (8) enden mehrere einander funktionsmäßig zugeordnete Leiterbahnen (2) paarweise. In den paarweise angeordneten Enden der zugeordneten Leiterbahnen (2) in den Schnittstellen (8) befinden sich durchkontaktierte Bohrungen (9), in die jeweils eine Kontaktbrücke (10) eingesetzt ist. Jede Kontaktbrücke (10) besteht aus zwei durch einen Steg (15) miteinander verbundenen Stiften (14). Die Stifte (14) durchsetzen die Bohrungen (9). Im Betriebszustand der Leiterplatte überbrücken mehrere Kontaktbrücken (10) jede Schnittstelle (8). Für Prüf- und Wartungszwecke sind die Kontaktbrücken leicht zu entfernen und danach wieder einzusetzen. In allen Schnittstellen (8) ist die Verdrahtung der Leiterplatte aufgetrennt. Die Lage jeder Schnittstelle (8) ist innerhalb eines Verbindungsbereiches (13) variabel. Auf jeder Bestückungsfläche (12) können gesondert abgeschlossene elektrische Funktionsgruppen angebracht werden, die über die angrenzenden Schnittstellen (8) gesondert prüfbar sind. Eine derart bestückte Leiterplatte (1) ist funktionsmäßig entflochten und rationell zu erstellen (Figur 2).

FIG 2

0047935

SIEMENS AKTIENGESELLSCHAFT
Berlin und München

Unser Zeichen
VPA 80 P 3 1 6 9 E

Leiterplatte

Die Erfindung betrifft eine Leiterplatte mit Leiterbahnen zur Verdrahtung elektrischer Bauelemente.

Eine solche handelsübliche Leiterplatte besitzt kaschierte Leiterbahnen, die durch Ätzung auf die Leiterplatte aufgebracht sind. Eine derartige Leiterplatte kann mit einer großen Anzahl von Bauelementen bestückt werden. Durch die Miniaturisierung elektrischer Bauelemente hat die Bestückungsdichte von Leiterplatten ständig zugenommen. Mit steigender Bestückungsdichte steigt jedoch der Aufwand für die Prüfung der Funktionen einzelner elektronischer Bauelemente oder von Gruppen aus elektronischen Bauelementen erheblich an. Eine hohe Bestückungsdichte der Leiterplatte bedeutet daher für die Prüfung der auf ihr vorhandenen elektronischen Bauelemente oder Funktionsbaugruppen einen hohen, z.T. nicht mehr vertretbaren Aufwand.

Der Erfindung liegt die Aufgabe zugrunde, eine Leiterplatte der eingangs genannten Art so auszugestalten, daß sie bei hoher Bestückungsdichte prüf- und wartungsfreundlich ist.

Erfindungsgemäß wird diese Aufgabe dadurch gelöst, daß die Verdrahtung auf der Leiterplatte eine Schnittstelle aufweist, in der mehrere einander funktionsmäßig zugeordnete Leiterbahnen enden, die paarweise durch je ein Verbindungselement gesondert elektrisch leitend miteinander verbunden sind.

Fi 2 Mka/18.08.1980

Bei der erfindungsgemäßen Leiterplatte erfolgt längs
einer Schnittstelle eine Auftrennung der Leiterbahnen.
Die paarweise in der Schnittstelle endenden Leiterbahnen
sind im Betriebszustand durch Verbindungselemente elektrisch leitend miteinander verbunden, wodurch die Schnittstelle überbrückt ist. Bei einer Prüfung von Bauelementen
werden die zugeordneten Leiterbahnen durch Entfernen der
Verbindungselemente aufgetrennt, so daß an die offenen
Enden der paarweise funktionsmäßig zugeordneten Leiterbahnen Prüfeinrichtungen, beispielsweise Meßfühler oder
Prüfadapter, anschließbar sind. Nach Beendigung einer
Prüfung ist durch die Verbindungselemente der Betriebszustand der Leiterplatte schnell wieder herstellbar.
Eine derartige Prüfung ist leicht durchführbar.

Vorteilhaft ist es, die Leiterplatte durch die Schnittstelle ihrer Verdrahtung in zwei Bestückungsflächen zu
unterteilen, weil eine von einer Kante zur gegenüberliegenden Kante der Leiterplatte durchgehende Schnittstelle
die auf den Bestückungsflächen angebrachten Bauelemente
in zwei abgeschlossene Gruppen unterteilt, die jeweils
einer gesonderten Prüfung zugänglich sind.

Vorteilhaft ist es, die Leiterplatte durch mehr als eine
Schnittstelle ihrer Verdrahtung rasterartig in mehrere
Bestückungsflächen zu unterteilen, weil mehrere abgeschlossene Baugruppen jeweils einer gesonderten Prüfung
zugänglich sind.

Vorteilhaft ist es, daß die Lage jeder Schnittstelle innerhalb eines Verbindungsbereiches variabel ist, weil
damit die Größe jeder Bestückungsfläche dem erforderlichen Flächenbedarf der Bauelemente angepaßt werden kann.
Eine derartige Leiterplatte ist vielseitiger verwendbar.

Vorzugsweise verläuft jede Schnittstelle parallel zu den Kanten der Leiterplatte, weil dadurch die Übersichtlichkeit auf der Leiterplatte verbessert wird und die Endpunkte der Schnittstellen an den gegenüberliegenden Kanten der Leiterplatte jeweils gleiche Abstände von einer der beiden zur Schnittstelle parallelen Kanten der Leiterplatte aufweisen.

Vorteilhaft ist es, daß jede Schnittstelle Bohrungen im Ende jeder Leiterbahn zur Aufnahme einer Kontaktbrücke als Verbindungselement besitzt, die aus zwei durch einen Steg miteinander verbundenen Stiften besteht, weil dadurch eine mechanisch leicht einsetzbare und wieder lösbare elektrisch leitende Verbindung zwischen den einander funktionsmäßig zugeordneten Leiterbahnen möglich ist.

Vorzugsweise ist jede Bohrung jeder Schnittstelle durchkontaktiert, weil dadurch der Kontakt zwischen jeder Leiterbahn und dem in der zugehörigen Bohrung befindlichen Stift der Kontaktbrücke inniger wird.

Vorteilhaft ist es, mehrere Kontaktbrücken parallel und im Abstand der Bohrungen anzuordnen, wobei die Stege aller Kontaktbrücken durch einen Gurt elektrisch isoliert miteinander verbunden sind, weil mehrere Kontaktbrücken gleichzeitig aus der Schnittstelle entfernt und damit mehrere Leiterbahnen gleichzeitig aufgetrennt werden können. Nach erfolgter Prüfung können ebenso mehrere Kontaktbrücken gleichzeitig in die Bohrungen der Schnittstelle eingesetzt werden. Ebenso können Prüfadapter so ausgebildet sein, daß sie gleichzeitig in mehrere paarweise angeordnete Bohrungen eingesteckt und wieder aus den Bohrungen entfernt werden können.

Vorzugsweise ist der Steg jeder Kontaktbrücke federnd ausgebildet, damit Toleranzen bei der Anordnung der Bohrungen beim Einsetzen der Kontaktbrücken ausgeglichen werden.

Vorzugsweise enthält jede Bestückungsfläche eine gesondert abgeschlossene elektrische Funktionsgruppe, weil dadurch die gesamte Bestückung der Leiterplatte in Funktionsgruppen aufgetrennt ist und ein rationeller Aufbau der Leiterplatte ermöglicht wird. Eine derart bestückte Leiterplatte ist funktionsmäßig entflochten. Eine derart normierte Entflechtung ist durch ein Programm speicherbar und damit für Leiterplatten gleicher Bestückung beliebig oft verfügbar. Durch ein solches Entflechtungsprogramm kann die Lage der Schnittstellen problemlos auf Leiterplatten übertragen werden, die mit gleicher Bestückung versehen werden. Die Bestückung mit elektrischen Funktionsgruppen, die jeweils aus mehreren elektrischen Bauelementen bestehen, verringert den Entwicklungsaufwand für den Aufbau der Leiterplatte und ermöglicht den Aufbau von Leiterplatten nach dem Baukastenprinzip. Bei Verwendung von elektrischen Funktionsgruppen kann innerhalb der Bestückung der Leiterplatte eine partielle Änderung oder eine partielle Innovation, beispielsweise durch ein neues elektrisches Bauelement, ohne besonderen Aufwand berücksichtigt werden. Dabei wird lediglich die Bestückung der betreffenden elektrischen Funktionsgruppen geändert, so daß nicht die Bestückung der gesamten Leiterplatte geändert werden muß. Jede elektrische Funktionsgruppe ist über angrenzende Schnittstellen gesondert prüfbar. Eine elektrische Funktionsgruppe ist beispielsweise ein aus der DE-OS 26 42 239 bekannter Richtimpulsgeber.

Vorteilhaft ist es, daß jeder Stift jeder Kontaktbrücke vom Steg ausgehend aus einem zylindrischen Teil, einem wulstartigen Teil mit einem den Durchmesser des zylindrischen Teils übertreffenden Durchmesser und einem kegelstumpfartigen Teil besteht, wobei die Länge des zylindrischen Teils etwa der Dicke der Leiterplatte entspricht, der kegelstumpfartige Teil im Anschluß an den wulstartigen Teil den Durchmesser des zylindrischen Teils aufweist und sich zum Ende des Stiftes hin verjüngt und wobei die drei Teile einen durchgehenden Ausschnitt längs der Stegachse aufweisen, weil dadurch jeder eine Bohrung durchsetzende Stift jeder Kontaktbrücke mit seinem wulstartigen Teil an der Unterseite der Leiterplatte die Öffnung der Bohrung hintergreift und dadurch einen festen und leicht lösbaren Sitz jedes Stiftes der Kontaktbrücke in der Leiterplatte bewirkt. Der durchgehende Ausschnitt längs der Stegachse bewirkt ein federndes Verhalten des Stiftes beim Einstecken und Lösen. Der kegelstumpfartige Teil jedes Stiftes dient zur leichteren Einführung des Stiftes in die Bohrung.

Vorteilhaft ist es, daß jeder Stift jeder Kontaktbrücke aus einem zylindrischen Teil besteht, der an seinem dem Steg abgewandten Ende eine kegelstumpfartige Verjüngung und längs der Stegachse einen durchgehenden Ausschnitt aufweist, weil ein derartiger Stift leicht federnd durch jede Bohrung durchführbar ist.

Die erfindungsgemäße Leiterplatte wird im folgenden beispielhaft anhand der Figuren 1 bis 5 dargestellt und beschrieben. Die in den Figuren auftretenden gleichen Bauelemente sind mit gleichen Bezugszeichen versehen.

In Figur 1 ist die erfindungsgemäße Leiterplatte mit schematisch angedeuteten Leiterbahnen zur Verdrahtung elektrischer Bauelemente dargestellt. Eine Leiterplatte 1 enthält mehrere Leiterbahnen 2. Ein Ende jeder Leiterbahn 2 befindet sich an den Kanten 3 und 4 der Leiterplatte 1, wo jede Leiterbahn mit einer äußeren Zuleitung elektrisch leitend verbunden ist. Durch die Leiterbahnen 2, die als kaschierte Leiterbahnen durch Ätzung auf die Leiterplatte 1 aufgebracht sind, sind elektrische Bauelemente 7 verdrahtet. Die Gesamtheit aller Leiterbahnen 2 stellt die Verdrahtung, die auch als Leiterbild bezeichnet wird, für alle elektrischen Bauelemente 7 dar. Ein Teil der Leiterbahnen 2 ist in der Schnittstelle 8 unterbrochen. In der Schnittstelle 8 enden mehrere einander funktionsmäßig zugeordnete Leiterbahnen 2 paarweise an den Stellen 9. Zwischen jeweils zwei einander zugeordneten Enden 9 einer Leiterbahn 2 in der Schnittstelle 8 befindet sich je ein Verbindungselement 10, das die beiden einander zugeordneten Teile 2a und 2b jeder aufgetrennten Leiterbahn 2 gesondert elektrisch leitend miteinander verbindet. Jedes Verbindungselement kann mechanisch lösbar oder eine nachträgliche Lötverbindung sein. Die Schnittstelle 8 verläuft zwischen der Kante 5 der Leiterplatte und einer Stelle 11 auf der Leiterplatte. In Figur 1 ist die Verlängerung der Schnittstelle 8 über die Stelle 11 hinaus bis zur Kante 6 der Leiterplatte 1 durch unterbrochene Linien angedeutet. Eine zwischen den Kanten 5 und 6 der Leiterplatte 1 verlaufende durchgehende Schnittstelle 8 unterteilt die Leiterplatte 1 in zwei Bestückungsflächen 12. Auf jeder Bestückungsfläche 12 kann eine Gruppe von funktionsmäßig zusammengehörigen elektronischen Bauelementen angebracht werden. Eine solche elektrische Funktionsgruppe ist beispielsweise der aus der DE-OS 26 42 239 bekannte Richtimpulsgeber. Eine elektrische Funktionsgruppe kann über die Schnittstelle 8 als geschlossene Gruppe gesondert geprüft und gewartet werden. Die Enden 9 der aufgetrennten Leiterbahnen 2 sind Bohrungen zur Aufnahme von Kontaktbrücken als Verbindungselemente 10. Jede Kontaktbrücke 10 ist in jeweils zwei paarweise angeordnete Bohrungen 9 einsteckbar. Die Schnittstelle 8 verläuft parallel zu den Kanten 3 und 4 der Leiterplatte 1.

In Figur 2 ist eine erfindungsgemäße Leiterplatte 1 dargestellt, die durch mehrere Schnittstellen 8 ihrer Verdrahtung rasterartig in mehrere Bestückungsflächen 12 unterteilt ist. Der Aufbau jeder Schnittstelle 8 und die Verbindung mit den Leiterbahnen 2 ist im Zusammenhang mit Figur 1 beschrieben. Jede Schnittstelle 8 verläuft von einer Kante der Leiterplatte 1 zu der jeweils gegenüberliegenden Kante und parallel zu einer der Kanten der Leiterplatte 1. Wegen dieses Verlaufs der Schnittstellen 8 können Prüfadapter einer Standardausführung für nahezu alle Leiterplatten 1 mit Bestückungsflächen 12 unterschiedlicher Größe anstelle von speziellen, nur bei jeweils einer einzelnen Leiterplatte einsetzbaren Prüfadaptern verwendet werden. Jede Schnittstelle 8 liegt innerhalb eines mit unterbrochenen Linien dargestellten Verbindungsbereiches 13. Innerhalb jedes Verbindungsbereiches 13 ist die zugehörige Schnittstelle 8 variabel angeordnet. Jeder Verbindungsbereich 13 verläuft zwischen den jeweils gegenüberliegenden Kanten 3 und 4 bzw. 5 und 6 der Leiterplatte 1. Das Raster der Schnittstellen 8 und damit die Lage jeder einzelnen Schnittstelle 8 wird jeweils für eine bestimmte Bestückung der Leiterplatte 1 durch den Flächenbedarf für die Bauelemente 7 oder die elektrischen Funktionsgruppen, mit denen die Leiterplatte 1 bestückt werden soll, festgelegt. Bei Belegung jeder Bestückungsfläche 12 der Leiterplatte 1 mit einer elektrischen Funktionsgruppe ist die Leiterplatte funktionsmäßig entflochten. Eine derart vereinbarte Entflechtung ist eine normierte Entflechtung, die durch ein Programm speicherbar ist und für Leiterplatten gleicher Bestückung beliebig oft verfügbar ist. Jede einzelne elektrische Funktionsgruppe kann über eine angrenzende Schnittstelle 8 geprüft werden. In jeder Schnittstelle 8 kann die Lage der einzelnen Leiterbahnfunktionen, beispielsweise die Zuführung von Versorgungsspannungen und von Steuer- und Regelsignalen zu einer Funktionsgruppe und elektrisch leitende Verbindungen zu anderen Funktionsgruppen auf der Leiterplatte festgelegt werden. Bei der Entwicklung des Aufbaus der Leiterplatte 1 wird die Lage jeder Schnittstelle 8 innerhalb des jeweiligen Verbindungsbereiches 13 festgelegt. Die Größe jeder Bestückungsfläche 12 ist damit festgelegt und kann nicht über die angrenzenden Schnittstellen 8 hinausgehen. Die Verbindungsbereiche 13 bieten damit bei der Entwicklung der Funktionen auf der Leiterplatte 1 die Möglichkeit, das Raster der Schnittstellen 8 und damit die Größe jeder Bestückungsfläche 12 dem Flächenbedarf der erforderlichen elektrischen Funktionsgruppen anzupassen. Die Bestückung der Leiterplatte 1 kann mit einem programmgesteuerten Bestückungsautomaten erfolgen. Bei der Bestückung der Leiterplatte mit elektrischen Funktionsgruppen wird für jede elektrische Funktionsgruppe ein spezielles Bestückungsprogramm als Teilprogramm zugrunde gelegt. Durch additives Zusammenfügen bestimmter Teilprogramme ergibt sich die gesamte Bestückung der Leiterplatte. Die unterschiedliche Bestückung von Leiterplatten für verschiedene Funktionen kann aus den verschiedenen Kombinationen der vorhandenen Teilprogramme für elektrische Funktionsgruppen erstellt werden. Bei Verfügbarkeit jedes einzelnen elektrischen Bauelementes jeder elektrischen Funktionsgruppe ist die Lagerhaltung kostengünstig, weil jedes einzelne Bauelement durch entsprechende Teilprogramme verschiedenen elektrischen Funktionsgruppen zugeordnet werden kann.

Dieses Schema für den Aufbau von Leiterplatten kann für die Entwicklung von Großleiterplatten verwendet werden. Bei Wahl einer bestimmten Leiterplattengröße, beispielsweise des Formats der Europakarte oder der Doppeleuropakarte, als Maß für ein Raster können mehrere Leiterplatten zu einer Großleiterplatte zusammengesetzt werden. Jede einzelne Leiterplatte der Großleiterplatte wird für bestimmte Funktionen mit elektrischen Funktionsgruppen bestückt. Eine solche Großleiterplatte ist daher ebenso wie eine einzelne Leiterplatte 1 entwicklungs- und prüffreundlich aufgebaut. Durch die Wahl eines IEC- und DINkompatiblen Rasters wird die Möglichkeit geschaffen, Großleiterplatten norm- und damit systemkompatibel zu erstellen und diese transversal, horizontal und vertikal in einen Baugruppenträger, beispielsweise des Systems Siemens ES 902, einzusetzen. Die für die Teilfunktionen gespeicherten Entflechtungen können additiv zu größeren Funktionseinheiten geplottet werden.

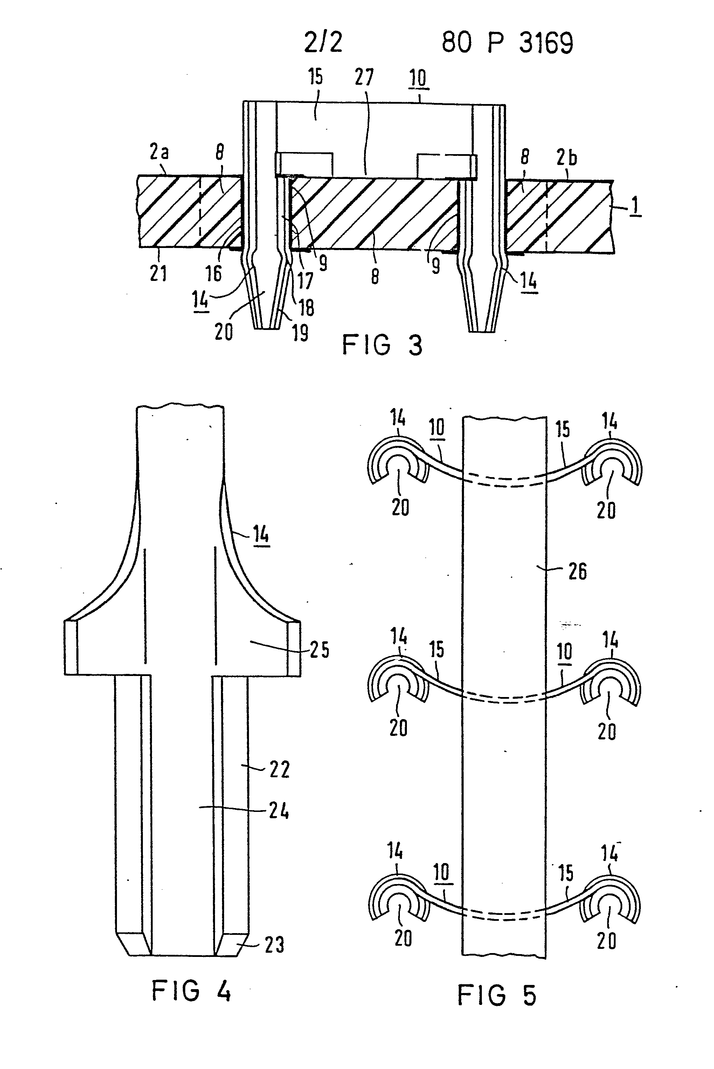

In Figur 3 ist eine Kontaktbrücke 10 dargestellt. Jede Kontaktbrücke 10 besteht aus zwei Stiften 14, die durch einen Steg 15 elektrisch leitend miteinander verbunden sind. Die beiden Stifte 14 der Kontaktbrücke 10 sind in die paarweise angeordneten Bohrungen 9 innerhalb der Schnittstelle 8 eingesetzt. Jede Bohrung 9 ist mit einem zugeordneten Leiterbahnabschnitt 2a bzw. 2b der aufgetrennten Leiterbahn 2 elektrisch leitend verbunden. Jede Bohrung 9 ist mittels eines elektrisch leitenden Belages 16 durchkontaktiert. Dadurch wird die Kontaktgabe zwischen den Stiften 14 und den zugehörigen Leiterbahnabschnitten 2a und 2b der aufgetrennten Leiterbahn 2 inniger. Jeder Stift 14 jeder Kontaktbrücke 10 besteht aus einem an den Steg 15 anschließenden zylindrischen Teil 17, einem an den Teil 17 anschließenden wulstartigen Teil 18 mit einem den Durchmesser des zylindrischen Teils 17 übertreffenden Durchmesser und einem kegelstumpfartigen Teil 19. Die Länge des zylindrischen Teils 17 entspricht der Dicke der Leiterplatte 1. Der Durchmesser des kegelstumpfartigen Teiles 19 besitzt im Anschluß an den wulstartigen Teil 18 den Durchmesser des zylindrischen Teils 17 und verjüngt sich zum Ende des Stiftes 14 hin. Die drei Teile 17, 18 und 19 des Stiftes 14 weisen einen durchgehenden Ausschnitt 20 längs der Stegachse auf. Der Ausschnitt 20 bewirkt ein federndes Verhalten jedes Stiftes 14 und ermöglicht ein konzentrisches Zusammendrücken des Stiftes 14 beim Durchstecken durch die Bohrung 9. Der wulstartige Teil 18 des Stiftes 14 weitet sich nach dem Durchsetzen der Bohrung 9 durch das elastische Verhalten des Stiftes auf seinen ursprünglichen Durchmesser aus und hintergreift die untere Öffnung der Bohrung 9 an der Unterseite 21 der Leiterplatte 1. Ein vom Steg 15 ausgehender Anschlag 27 verhindert ein Austreten des zylindrischen Teiles 17 aus der unteren Öffnung der Bohrung 9 und bewirkt eine definierte Lage des wulstartigen Teiles 18 an der Unterseite 21. Dadurch wird ein mechanisch fester und lösbarer Sitz für die beiden Stifte 14 in den paarweise zugeordneten Bohrungen 9 erreicht und die Kontaktbrücke 10, die als Kurzschlußbügel die Schnittstelle 8 überbrückt, erhält einen festen Sitz auf der Leiterplatte 1. Der Steg 15 jeder Kontaktbrücke 10 ist federnd ausgebildet.

In Figur 4 ist eine weitere Ausbildung für die beiden Stifte 14 jeder Kontaktbrücke 10 dargestellt. Ein zylindrischer Teil 22 mit einer kegelstumpfartigen Verjüngung 23 schließt sich an einen Anschlag 25 an. Längs der Stegachse besitzen der zylindrische Teil 22 und der kegelstumpfartige Teil 23 einen Ausschnitt 24. Der zylindrische Teil 22 des Stiftes 14 durchsetzt im eingesetzten Zustand eine der Bohrungen 9.

In Figur 5 ist eine Anordnung mehrerer Kontaktbrücken 10 dargestellt. Alle Kontaktbrücken 10 sind parallel zueinander angeordnet. Der Abstand zwischen zwei benachbarten Kontaktbrücken 10 entspricht dem Abstand zwischen zwei benachbarten Paaren von Bohrungen 9 in einer Schnittstelle 8 (Figur 1 und 2), so daß die beiden Stifte 14 jeder Kontaktbrücke 10 sich jeweils in der Position von paar-

0047935
VPA 80 P 3 1 6 9 E

weise angeordneten Bohrungen 9 befinden. Die Stege 15 aller Kontaktbrücken 10 sind durch einen Gurt 26 elektrisch isoliert und mechanisch fest miteinander verbunden. Mit einer solchen Anordnung können die Abschnitte mehrerer in einer Schnittstelle 8 aufgetrennter Leiterbahnen 2 gleichzeitig elektrisch miteinander verbunden werden. Wegen der elastischen Ausbildung der Stege 15 können beim Einsetzen einer solchen Anordnung in mehrere Bohrungen 9 in der Schnittstelle 8 Toleranzen der Bohrungen 9 ausgeglichen werden.

Patentansprüche

1. Leiterplatte mit Leiterbahnen zur Verdrahtung elektrischer Bauelemente, d a d u r c h   g e k e n n - z e i c h n e t , daß die Verdrahtung auf der Leiterplatte (1) eine Schnittstelle (8) aufweist, in der mehrere einander funktionsmäßig zugeordnete Leiterbahnen (2, 2a, 2b) enden, die paarweise durch je ein Verbindungselement (10) gesondert elektrisch leitend miteinander verbunden sind.

2. Leiterplatte nach Anspruch 1, d a d u r c h   g e - k e n n z e i c h n e t , daß die Leiterplatte (1) durch die Schnittstelle (8) ihrer Verdrahtung in zwei Bestückungsflächen (12) unterteilt ist.

3. Leiterplatte nach Anspruch 1 oder 2, d a d u r c h g e k e n n z e i c h n e t , daß die Leiterplatte (1) durch mehr als eine Schnittstelle (8) ihrer Verdrahtung rasterartig in mehrere Bestückungsflächen (12) unterteilt ist.

4. Leiterplatte nach einem der Ansprüche 1 bis 3, d a - d u r c h   g e k e n n z e i c h n e t , daß die Lage jeder Schnittstelle (8) innerhalb eines Verbindungsbereiches (13) variabel ist.

5. Leiterplatte nach einem der Ansprüche 1 bis 4, d a - d u r c h   g e k e n n z e i c h n e t , daß jede Schnittstelle (8) parallel zu den Kanten (3, 4, 5, 6) der Leiterplatte (1) verläuft.

6. Leiterplatte nach einem der Ansprüche 1 bis 5, d a - d u r c h   g e k e n n z e i c h n e t , daß jede Schnittstelle (8) Bohrungen (9) im Ende jeder Leiterbahn (2) zur Aufnahme einer Kontaktbrücke (10) als Verbindungselement besitzt, die aus zwei durch einen Steg (15) miteinander verbundenen Stiften (14) besteht.

7. Leiterplatte nach Anspruch 6, d a d u r c h   g e - k e n n z e i c h n e t  , daß jede Bohrung (9) jeder Schnittstelle (8) durchkontaktiert ist.

8. Leiterplatte nach Anspruch 6 oder 7, d a d u r c h   g e k e n n z e i c h n e t  , daß mehrere Kontakt- brücken (10) parallel und im Abstand der Bohrungen (9) angeordnet sind, wobei die Stege (15) aller Kontaktbrükken.(10) durch einen Gurt (26) elektrisch isoliert miteinander verbunden sind.

9. Leiterplatte nach Anspruch 8, d a d u r c h   g e - k e n n z e i c h n e t  , daß der Steg (15) jeder Kontaktbrücke (10) federnd ausgebildet ist.

10. Leiterplatte nach einem der Ansprüche 2 bis 9, d a - d u r c h   g e k e n n z e i c h n e t  , daß jede Bestückungsfläche (12) eine gesondert abgeschlossene elektrische Funktionsgruppe enthält.

11. Leiterplatte nach einem der Ansprüche 6 bis 9, d a - d u r c h   g e k e n n z e i c h n e t  , daß jeder Stift (14) jeder Kontaktbrücke (10) vom Steg (15) ausgehend aus einem zylindrischen Teil (17), einem wulstartigen Teil (18) mit einem den Durchmesser des zylindrischen Teils (17) übertreffenden Durchmesser und einem kegelstumpfartigen Teil (19) besteht, wobei die Länge des zylindrischen Teils (17) etwa der Dicke der Leiterplatte (1) entspricht, der kegelstumpfartige Teil (19) im Anschluß an den wulstartigen Teil (18) den Durchmesser des zylindrischen Teils (17) aufweist und sich zum Ende des Stiftes (14) hin verjüngt und wobei die drei Teile (17, 18, 19) einen durchgehenden Ausschnitt (20) längs der Stegachse aufweisen.

12. Leiterplatte nach einem der Ansprüche 6 bis 9, d a -
d u r c h   g e k e n n z e i c h n e t , daß jeder
Stift (14) jeder Kontaktbrücke (10) aus einem zylindrischen Teil (22) besteht, der an seinem dem Steg (15) abgewandten Ende eine kegelstumpfartige Verjüngung (23)
und längs der Stegachse einen durchgehenden Ausschnitt (24)
aufweist.

FIG 1

FIG 2

FIG 3

FIG 4

FIG 5